**Europäisches Patentamt**

**European Patent Office**

**Office européen des brevets**

(19)

(11) Veröffentlichungsnummer: **0 191 905 B1**

(12) **EUROPÄISCHE PATENTSCHRIFT**

(45) Veröffentlichungstag der Patentschrift: **27.03.91**

(51) Int. Cl.⁵: **H05K 13/00**

(21) Anmeldenummer: **85113972.5**

(22) Anmeldetag: **03.11.85**

(54) **Vorrichtung zum Ausrichten und Festlegen einer Trägerplatte für gedruckte Schaltungen, mittels Bezugsstiften mit veränderlichem Durchmesser.**

(30) Priorität: **14.02.85 IT 1951485**

(43) Veröffentlichungstag der Anmeldung:
**27.08.86 Patentblatt 86/35**

(45) Bekanntmachung des Hinweises auf die
Patenterteilung:
**27.03.91 Patentblatt 91/13**

(84) Benannte Vertragsstaaten:
**CH DE FR GB IT LI SE**

(56) Entgegenhaltungen:
**EP-A- 0 002 496**

(73) Patentinhaber: **Curti, Ezio**
**Strada Padana Superiore 57/59**
**I-20063 Cernusco sul Naviglio(IT)**

(72) Erfinder: **Curti, Ezio**
**Strada Padana Superiore 57/59**
**I-20063 Cernusco sul Naviglio(IT)**

(74) Vertreter: **Mayer, Hans Benno, Dipl.-Ing.**
**de Dominicis & Mayer Piazzale Marengo 6**
**I-20121 Milano(IT)**

**Beschreibung**

Die vorstehende Erfindung betrifft eine Vorrichtung zum Ausrichten und Festlegen einer Traegerplatte fuer geruckte Schaltungen, unter Zuhilfenahme von Bezugsstiften, die in bekannter Weise mit in die Traegerplatte eingebrachten Bezugsbohrungen in Wirkverbindung gebracht werden.

Es ist z.B. zum genauen Ausrichten von Traegerplatten fuer elektrische Schaltungen, die mittels Siebdruckverfahren auf die Traegerplatte aufgebracht werden, bekannt, dass die Traegerplatten an geigneten Stellen kleine Bohrungen aufweisen, die mit Bezugsstiften in Wirkverbindung gebracht werden. Diese Bezugsstifte, die einen Durchmesser von wenigen Millimetern aufweisen, werden lagemaessig gegenueber der Siebdruckeinheit justiert und eingestellt, im Anschluss daran werden die Bezugsstifte mit den Bezugsbohrungen der Traegerplatten in Verbindung gebracht.

Aus EP-A-0002496 ist ferner eine Vorrichtung zum Ausrichten flacher dünner Werkstücke, z.B. Platten, Folienelemente bekannt.

Waehrend sich dar Festlegen der Traegerplatten mittels Bezugsstiften als guenstig und vorteilhaft erwiesen hat, wurden von der Fachwelt Nachteile fuer dieses Verfahren bei Verwendung in automatisch arbeitenden Anlagen festgestellt, da in automatischen Anlagen eine staendige Steigerung der Arbeitsgeschwindigkeit festzustellen ist. Hauptsaechlich wurden in diesen Hochleistungsanlagen Schwierigkeiten beim Ausrichten und schnellen Festlegen der Platten mittels fest angeordneten Bezugsstiften und Bezugsbohrungen festgestellt.

Diese Schwierigkeiten beim gegenseitigen Verbindung zwischen Platte und Bezugsstift, sind einmal auf die sehr geringen Abmessungen der Bezugsstifte und der Bezugsbohrungen zurueckzufuehren. Aufgrund unvermeidbarer Teilungsfehler zwischen den Bezugssbohrungen, die sich aufgrund von Laengenaenderungen der Traegerplatte (bedingt durch Temperaturschwankungen) einstellen, wurden auch Schwierigkeiten bei der Verbindung zwischen Stift und Bohrung aufgrund von Verformungen der Traegerplatte festgestellt. Dies fuehrt dazu, dass die angebotene hohe Produktionsleistung moderner Anlagen nicht ausgenuetzt werden kann, da staendig Stoerungen in der Beschickungsfolge, sowie waehrend des automatischen Ausricht- und Spannvorganges der Traegerplatte in der Maschine auftreten. Desweiteren treten unerwuenschte Beschaedigungen der Bezugsstifte auf, die dazu fuehren, dass der mittels Siebdruck durchgefuehrte Druckvorgang des elektronischen Schaltkreises Registerfehler aufweist.

Aufgabe der vorstehenden Erfindung ist es, diese Nachteile zu vermeiden und eine Vorrichtung vorzuschlagen, mit der die Traegerplatten schnell und genau in der Maschine ausgerichtet und gespannt werden koennen, wobei Bezugsstifte Verwendung finden, die geeignet sind, jegliches Spiel zwischen der Bezugsbohrung und dem Bezugsstift und eventuelle Laengenaenderungen oder Verformungen der Traegerplatte, auszugleichen.

Diese Aufgaben werden erfindungsgemaess dadurch geloest, dass der Bezugsstift aus mehreren, Pängs der Axialrichtung getrennten Teilstuecken besteht und auf seiner, zur Bezugsbohrung gerichteten Seite, einen Zapfen aufweist, dessen Durchmesser kleiner als der Durchmesser der Bezugsbohrung ist, dass der zusammengesetzte Bezugsstift mit Spiel in einer Aufnahmehuelse gelagert ist, die Federmittel aufweist, die bestrebt sind, die Teilstrecke des Bezugsstiftes vereint zu halten, dass der Bezugsstift eine axiale Innenbohrung mit einem konischen Endsitz aufweist und, dass in dieser Bohrung ein axial verschiebbarer Stift gelagert ist, der an seinem freien Ende eine konische Spitze aufweist und mit seinem anderen Ende mit einem Kolben eines pneumatischen Antriebszylinders verbunden ist.

Mit einem derartig ausgebildeten Bezugsstift wird es ermoeglicht, einem elastisch verformbaren Bezugstift zur Loesung der erfindungsgemaessen Aufgabe vorzuschlagen, wobei der Bezugsstift fuer das Einfuehren in die Bezugsbohrung einen wesentlich kleinen Durchmesser als die Bezugsbohrung aufweist, und nach Einfuehren des Bezugsstiftes in die Bezugsbohrung die Moeglichkeit besteht, den Bezugsstift automatisch auseinanderzuspreizen, um somit die zu bedruckende Platte genau in der gewuenschten Lage festzulegen. Weiter Vorteile der Erfindung koennen der folgenden Beschreibung, den Unteranspruechen und den Zeichnungen entnommen werden. Der Erfindungsgegenstand wird in den Zeichnungen anhand eines Ausfuehrungsbeispieles dargestellt.

Es zeigen:

Fig. 1 schematisch zwei Bezugsstifte vor dem Einstecken in die Platte;

Fig. 2 die Bezugsstifte nach Fig. 1 unmittelbar nach Einfuehren der Stifte in die Bezugsbohrungen der Platte;

Fig. 3 die Platte und die Bezugsstifte in blockierter Stellung;

Fig. 4 schematisch in einer Draufsicht eine Platte mit zwei Bezugsbohrungen und den eingefuehrten Bezugsstiften;

Fig. 5 in einer Ansicht von oben den erfindungsgemaessen Bezugsstift in geschlossener Stellung;

Fig. 6 in einer Ansicht von oben den Bezugsstift nach Fig. 5 in offener Stellung;

Fig. 7 das Ende des Bezugsstiftes in einer perspektivischen Darstellung.

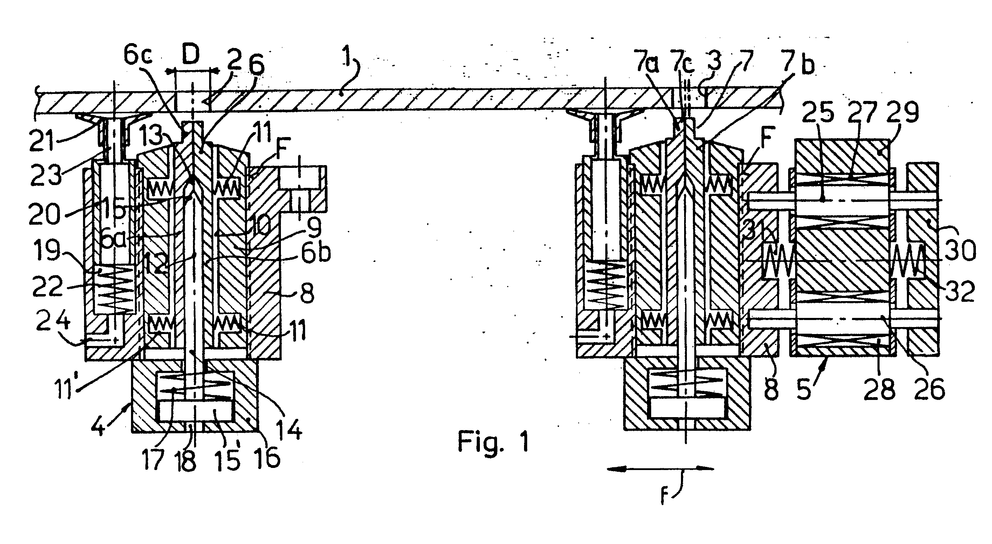

Wie der Fig. 1 zu entnehmen ist, sind unter einer Aufnahmeplatte 1, die zur Auflage der zu bedruckenden Platte des Schaltkreises dient, und die z.B. mit zwei Bezugsbohrungen 2 und 3 versehen ist, Vorrichtung 4 und 5 vorgesehen, von denen jede mit einem entsprechenden Bezugsstift 6 und 7 ausgeruestet ist, der mit den Bezugsbohrungen 2 und 3 verbindbar ist.

Die Vorrichtung 4 besteht aus einem Lagersupport 8, der unter Verwendung geeigneter Befestigungsmittel (Schrauben) mit dem Gestell der Siebdruckmaschine (nicht dargestellt) verbunden ist. In der Siebdruckmaschine werden automatisch die Traegerplatten 1 bedruckt.

Der Haltesupport 8 nimmt einen huelsenfoermigen Koerper 9 auf, der eine Axialbohrung 10 aufweist, in der mit geringem Radialspiel der Bezugsstift 6 aufgenommen wird. Der Bezugsstift besteht aus zwei Stifthaelften 6a und 6b. Um die Stifthaelften 6a und 6b des Bezugsstiftes 6 zusammenzuhalten, sind im Inneren der Lagerhuelse 9 Federmittel 11 vorgesehen, die in radial angeordneten Sitzen 11' angeordnet sind. Die Federmittel 11 sind bestrebt, jeweils eine Stifthaelfte 6a gegen die andere Stifthaelfte 6b zu druecken.

Das Ende 6c des Bezugsstiftes 6 weist einen Durchmesser (d) auf, der wesentlich kleiner als der Durchmesser (D) der Bezugsbohrung 2 ist.

Im Inneren des Bezugsstiftes 6 weist dieser eine Axialbohrung 12 auf, die in einem konisch zulaufenden Sitz 13 endet. In der Axialbohrung 12 ist verschiebbar ein Stift 14 angeordnet, der eine konisch ausgebildete Spitze 15 aufweist, die in Richtung des konischen Sitzes hin gerichtet ist. Der Stift 14 bildet die Stange eines Kolbens 15', der Bestandteil einer pneumatischen Kolbenzylindereinheit 16 ist, die an der Unterseite der Halterung 8 angebracht ist. Auf der einen Seite wird der Kolben 15' durch eine Rueckholfeder 17 beaufschlagt, wogegen auf der gegenueberliegenden Seite des Kolbens Druckluft angreift, die ueber die Oeffnung 18 des Zylinders 16 zugefuehrt wird.

Parallel und neben dem Bezugsstift 6 weist die Halterung 8 einen Sitz 19 auf, in dem ein in Laengsrichtung verschiebbares Rohr 20 gelagert ist, das an seiner Oberseite mit einem Sauger 21 wirkverbunden ist, der auf die Unterseite der Traegerplatte 1 gerichtet ist. Das Rohrstueck 20 liegt auf einer Feder 22 auf, die in der Kammer oder im Sitz 19 angeordnet ist. Diese Feder 22 ist bestrebt, den Sauger 21 stets in einer Lage zu halten, die ueber dem Endstueck 6c des Bezugsstiftes 6 zu liegen kommt. Der Sauger 21 ist ueber die Innenbohrung 23, das auf der Feder 22 aufliegende Rohr 20 und einen Kanal 24 mit einer Unterdruckquelle (nicht dargestellt) verbindbar.

Die Vorrichtung 5, die in den Figuren auf der rechten Zeichnungsseite dargestellt ist, besteht aus den gleichen Konstruktionselementen, wie bisher beschrieben, daher wurden fuer die Kennzeichnung dieser Bauteile die gleichen Bezugszeichen verwendet.

Der einzige Unterschied zwischen der Vorrichtung 4 und der Vorrichtung 5, die den Bezugsstift 7 aufnimmt, der aus zwei auseinanderspreizbaren Haelften 7a und 7b gebildet ist, die an ihrem oberen Ende im Endstueck 7c mit geringerem Durchmesser auslaufen, besteht darin, dass der Haltesupport 8 nicht ortsfest gegenueber dem Maschinengestell angeordnet ist, sondern beweglich von zwei saeulenartigen, parallel in einer horizontalen Ebene angeordneten Gleitfuehrungen 25 und 26 aufgenommen ist. Die Fuehrungen 25 und 26 sind in Horizontalrichtung verschiebbar angeordnet und durch Kugellager 27 und 28, z.B. bekannte Kugelkaefige aufgenommen, die ihrerseits in einer Halterung 29 angeordnet sind, die fest am Maschinengestell vorgesehen ist. Die saeulenartigen Fuehrungen 25 und 26 stehen auf der, der Vorrichtung 5 abgewandten Seite, aus der Halterung 29 vor und diese vorstehenden Enden der Fuehrungen sind ueber ein Querjoch 30 fest miteinander verbunden.

In vorteilhafter Weise, sind zwischen dem Haltesupport 8 und der Halterung 29 Federmittel 31 vorgesehen, und auch zwischen der Halterung 29 und dem Verbindungstueck 30 sind in aehnlicher Weise Federmittel 32 vorgesehen. Die Federn 31 und 32 sind derartig bemessen und eingestellt, dass von ihnen stets die gleiche Federkraft aufgebracht wird. Somit wird gewaehrleistet, dass sich die Vorrichtung 5 stets in dar gleichen Lage gegenueber der Halterung 29 befindet.

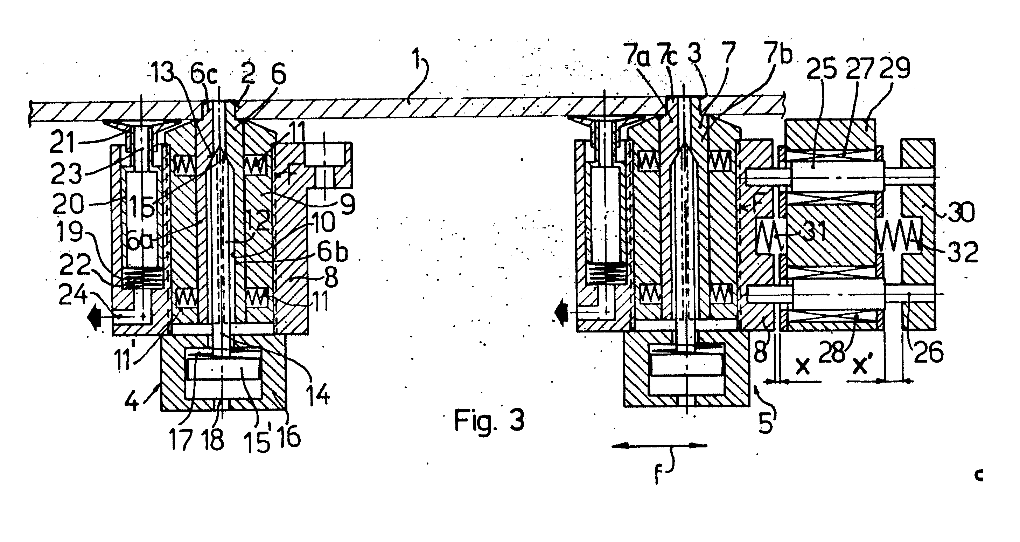

Die Arbeitsweise der bisher beschriebenen Vorrichtung kann genauer den Figuren 1 - 3 entnommen werden.

Wenn die Traegerplatte 1, unter Zuhilfenahme von an sich bekannten Mitteln, z.B. Saugern oder Greifzangen (nicht dargestellt), wie in Fig. 1 dargestellt, ueber den Vorrichtungen 4 und 5 ausgerichtet wird, so befindet sich die Bezugsbohrung 2 in Uebereinstimmung mit dem Ende 6c des Bezugsstiftes 6, der hier in geschlossener Stellung vorgesehen ist. Der Durchmesser (D) der Bohrung 2 ist groesser als der Durchmesser (d) des Endstueckes 6c des noch geschlossenen Bezugsstiftes 6.

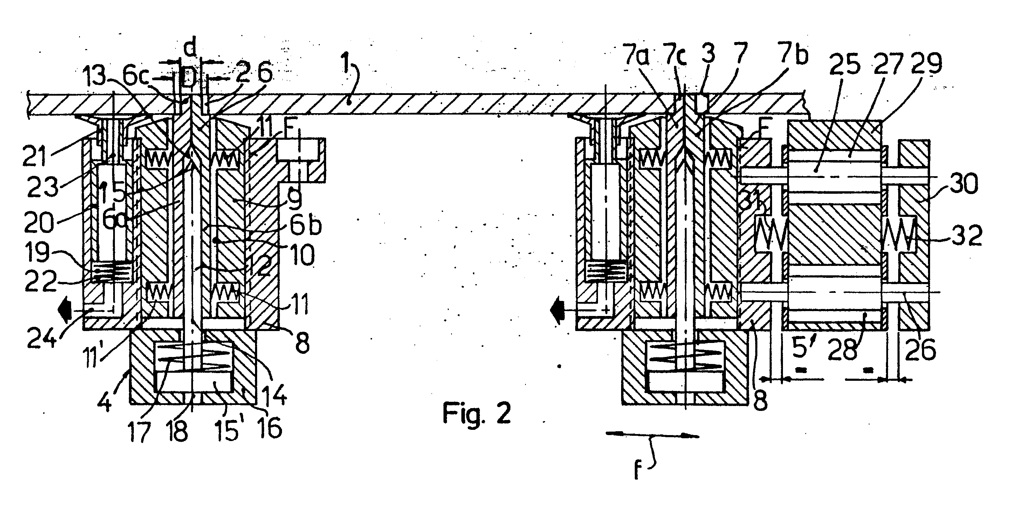

Auch die zweite Bohrung 3 befindet sich ungefaehr ueber dem Endstueck 7c des zweiten ebenfalls geschlossenen Bezugsstiftes 7 der Vorrichtung 5. Wie der Zeichnung entnommen werden kann, kann es in der Praxis ohne weiteres vorkommen, dass sich die Achse des Bezugsstiftes 7 versetzt gegenueber der Achse der Bezugsbohrung 3 befindet. Dieser Fehler stellt sich z.B. aufgrund thermischer Laengenaenderungen oder Verformungen der Traegerplatte 1 ein. In der Stellung gemaess Fig. 1 liegt die Traegerplatte auf den axial verschiebbar angeordneten Saugern 23 auf. Waehrend der Abwaertsbewegung der Traegerplatte 1 von der in Fig. 1 dargestellten Stellung in die in Fig. 2 dargestellte Stellung, ist erkennbar, dass die Sauger 23, da diese frei in Axialrichtung verschiebbar angeordnet sind, dieser Absenkbewegung der Traegerplatte 1 folgen. Aufgrund des ueber die Oeffnung 24 zugefuehrten Unterdruckes wird erzielt, dass auch im Falle einer geringfuegigen Verformung der Traegerplatte 1, diese Unregelmaessigkeit ausgeglichen wird und die Platte 1 genau mit ihren Bezugsbohrungen 2 und 3 ueber den Endstuecken 6c und 7c der Bezugsstifte 6 und 7 ausgerichtet wird.

Auch der Fig. 2 kann entnommen werden, dass die Bezugsbohrung 2 der Traegerplatte 1 koaxial zum Endstueck 6c des Bezugstiftes 6 der Vorrichtung 4 steht, aber die Bohrung 3 der Traegerplatte 1 geringefuegig gegenueber dem Endstueck 7c des Bezugssiftes 7 versetzt ist. Aufgrund des kleineren Durchmessers (d) der Endstuecke 6c und 7c gegenueber den groesseren Durchmessern (D) der Bohrungen 2 und 3 und, Dank der Vorsehung der mit Unterdruck beaufschlagten Sauger 21, koennen die Bezugsbohrungen 2 und 3 ohne jegliche Schwierigkeit mit den zugeordneten Bezugsstiften 6 und 7 in Verbindung gebracht werden.

Anschliessend, durch Zufuehrung von Druckluft ueber die Leitung 18 des entsprechenden Pneumatikzylinders 16, schieben die entsprechenden Kolben 15' die Stange 12 in das Innere der Bezugsstifte 6 bzw. 7, unter Durchfuehrung einer Aufwaertsbewegung gegen die Wirkung der entsprechenden Feder 17. Sobald die konischen Enden der Stange 18 den konischen, innenliegenden Endsitz der Axialbohrung eines jeden Bezugsstiftes 6 bzw. 7 erreichen, erfolgt ein Auseinderspreizen der beiden Stifthaelften 6a und 6b bzw. 7a und 7b der Bezugsstifte 6 und 7 (Spreizung, die gegen die Kraftwirkung der Federn 11 erfolgt). Dadurch treten die Enden 6c bzw. 7c in Beruehrung mit den Waenden der Bezugsbohrungen 2 bzw. 3.

Waehrend die Bohrung 2 koaxial zum Bezugsstift 6 dargestellt wurde, ist die Bezugsbohrung 3 im Beispiele nach Fig. 1 - 3 exzentrisch gegenueber der Laengsachse des Bezugsstiftes 7 dargestellt.

Um zu vermeiden, dass sich in diesem Falle Verformungen oder sogar Brueche an der Spitze des Bezugsstiftes 7 bzw. des Endzapfens 7c einstellen (diese Endzapfen weisen Abmessungen von wenigen Millimetern auf), ist erfindungsgemaess vorgesehen, dass die Vorrichtung 5 ueber Fuehrungen 25 und 26 hin und her verschiebbar (Pfeil f) gelagert wird, wodurch bei Betaetigen des Pneumatikzylinders 16 und Aufspreizen der Stifthaelften 7a und 7b des Bezugstiftes 7 aufgrund der eindringenden Stange 12, durch den Bezugsstift 7 eine geringfuegige Ausgleichbewegung durchfuehrbar

ist, da sich der Bezugsstift 7 unter Durchfuehrung einer kleinen Ausgleichsbewegung nach recht verschieben kann, da die horizontal angeordneten saeulenartigen Fuehrungen 25 und 26 in den Lagern 27 und 28 der fest angeordneten Halterung 29 frei beweglich vorgesehen sind. Die Federn 31 und 32 sorgen als Rueckstelleinrichtung fuer die Vorrichtung 5 nach jedem Druckvorgang, wodurch die Vorrichtung stets in ihre Ausgangslage zurueckbewegt wird.

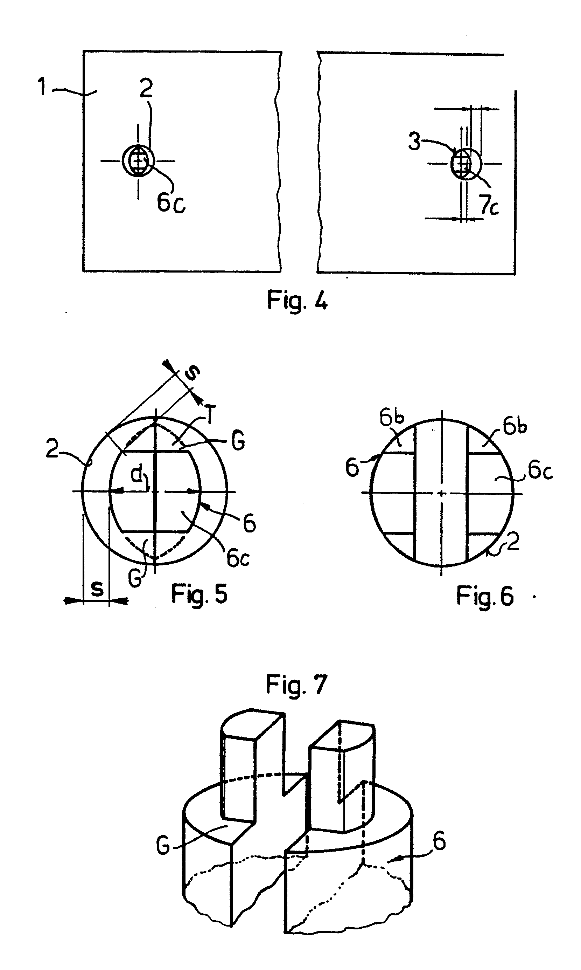

In Fig. 4 ist schematisch eine Traegerplatte 1 dargestellt, in deren Bezugsbohrungen 2 und 3 bereits die Enden 6c und 7c der entsprechenden Bezugsstifte eingesetzt sind. In Fig. 4 ist ferner dargestellt, dass die Enden 6c konzentrisch in die entsprechende Bohrung 2 eingefuehrt wurden, waehrend die Enden 7c exzentrisch gegenueber der Bohrung 3 eingefuehrt sind. Wie bereits vorher beschrieben, kann dieser Versatz durch die verschiebbare Lagerung der Vorrichtung 5 ausgeglichen werden.

In den Figuren 5 - 7 ist ein Endstueck, z.B. 6c des Bezugsstiftes 6 in einer Draufsicht bzw. in einer perspektivischen Ansicht dargestellt. Die Fig. 5 zeigt das Endstueck 6c des Bezugsstiftes 6 in geschlossener Stellung, waehrend die Fig. 6 den Bezugsstift 6 in offener Stellung zeigt. Der mittige Axialschnitt (T), der den Bezugsstift 6 in zwei Haelften teilt, ist derartig durchgefuehrt, dass der Durchmesser des Stiftes (d) derartig vermindert wird, dass sich die Moeglichkeit ergibt, das Endstueck 6c bei geschlossenem Bezugsstift 6 mit einem gewissen Spiel (S) in die Bezugsbohrung 2 der Traegerplatte 1 einzufuehren. Um zu vermeiden, dass aufgrund des verbleibenden Restdurchmessers, das Endstueck 6c waehrend des Einfuehrungsvorganges in die Bezugsbohrung 2 gegen die Wand dieser Bohrung anschlaegt, ist in vorteilhafter Weise vorgesehen, dass in Uebereinstimmung mit seinem Ende jeder Bezugsstift 6 bzw. 7 stufenartige Abfraesungen G aufweist, die eine zuruecktretende Ausnehmung bilden. Dadurch wird gewaehrleistet, dass auch fuer den verbleibenden Teilbereich der Bezugsbohrung 2 ein Spiel verbleibt, das wenigstens dem Wert S entspricht.

In Fig. 6 und 7 ist der Bezugsstift 6, 6c in geoeffneter Stellung dargestellt, d.h. in der Stellung, in der die Betaetigungsstange 14 nach oben verschoben wurde, um somit die zwei Stifthaelften 6a und 6b auseinanderzuspreizen. In dieser Stellung liegen die Aussenwaende des Stiftendes 6c, das annaehernd den gleichen Radius der Bezugsbohrung 2 aufweist, fest an der Wand der Bezugsbohrung an.

**Ansprüche**

1. Vorrichtung zum Ausrichten und Festlegen einer Traegerplatte fuer gedruckte Schaltungen, unter Zuhilfenahme von Bezugsstiften und Bezugsbohrungen, wobei jeder Bezugsbohrung (2,3) der Platte (1) ein Bezugsstift (6,7) zugeordnet ist, **dadurch gekennzeichnet** , dass der Bezugsstift aus mehreren, Pängs der Axialrichtung getrennten Teilstuecken (6a,6b,7a,7b) besteht, dass jeder Bezugsstift (6c,7c) auf seiner, zur Bezugsbohrung (2,3) gerichteten Seite, einen Zapfen (6c,7c) mit einem Durchmesser (d) aufweist, der kleiner ist als der Durchmesser (D) der Bezugsbohrung (2,3), dass der zusammengesetzte Bezugsstift (6,7) mit Spiel in einer Aufnahmehuelse (9) gelagert ist, die Federmittel (11) aufweist, die bestrebt sind, die Teilstuecke (6a,6b,7a,7b) des Bezugsstiftes (6,7) zusammenzuhalten, dass der Bezugsstift (6,7) im Inneren eine Axialbohrung (12) aufweist, die in einem konisch zulaufenden Sitz (13) endet und, dass in dieser Axialbohrung (12) axial verschiebbar ein Stift (14) gelagert ist, der an seinem freien Ende eine konisch zulaufende Spitze (15) aufweist, und mit seinem anderen Ende mit einem Kolben (15') verbunden ist, der Bestandteil eines pneumatischen Antriebszylinders (16) ist.

2. Vorrichtung, nach Patentanspruch 1, **dadurch gekennzeichnet** , dass die Federmittel (11) in radial angeordneten Sitzen (11') vorgesehen sind, die im Inneren der Aufnahmehülse (9) angeordnet sind.

3. Vorrichtung, nach Patentanspruch 1, **dadurch gekennzeichnet** , dass der axial verschiebbare Stift (14) in einem Kolben (15') endet, der durch eine Feder (17), nach Art eines einfach wirkenden Zylinders (16) beaufschlagt wird.

4. Vorrichtung, nach Patentanspruch 1 - 3 **dadurch gekennzeichnet** , dass parallel und neben dem Bezugsstift (6, bzw. 7) ein Lagersupport (8) vorgesehen ist der, eine Bohrung (19) aufweist, die ein rohrfoermiges, verschiebbar gelagertes Bauteil (20) aufnimmt, das an seiner Oberseite einen Sauger (21) traegt, der auf die Unterseite der Platte (1) gerichtet ist, dass die Unterseite des verschiebbaren rohrfoermigen Bauteils (2) auf einer Feder (17) aufliegt, die in der Bohrung (19) angeordnet ist und, dass die Bohrung (19) ueber eine Leitung (24) mit einer Unterdruckquelle wirkverbunden ist.

5. Vorrichtung, nach Patentanspruch 1 - 4 **dadurch gekennzeichnet** , dass wenigstens ein Lagersupport (8) durch zwei parallele horizontal angeordnete Fuehrungen (25, 26) gelagert ist, die ihrerseits in Horizontalrichtung verschiebbar in einem Lagerteil (29), das fest mit der Maschine verbunden ist, angeordnet sind.

6. Vorrichtung, nach Patentanspruch 5, **dadurch gekennzeichnet** , dass die Fuehrungen (25, 26) von dem Lagerteil (29) abstehen, und ihre freien Enden ueber ein Querjoch (30) miteinander verbunden sind und, dass zwischen dem Lagersupport (8) und dem Lagerteil (29), sowie dem Lagerteil (29) und dem Joch (30), Federmittel (31) angeordnet sind.

7. Vorrichtung, nach Patentanspruch 6, **dadurch gekennzeichnet** , dass die Federn (31, 32) gleiche Federkennlinie und gleiche Federvorspannung aufweisen.

8. Vorrichtung, nach Patentanspruch 1, **dadurch gekennzeichnet** , dass der Durchmesser (d) des Bezugsstiftes wesentliche kleiner als der Durchmesser (D) der Bezugsbohrung ist.

9. Vorrichtung, nach Patentanspruch 1, **dadurch gekennzeichnet** , dass die auf die Traegerplatte (1) zu gerichteten Enden (6c, 7c) der Bezugsstifte (6,7) parallele Einfraesungen aufweisen, die einen stufenartigen Ruecktritt (G) bilden.

## Claims

1. Device for aligning and fixing a substrate board for printed circuits using reference pins and reference holes, a reference pin (6, 7) being assigned to every reference hole (2, 3) of the board (1), characterised in that the reference pin is composed of a plurality of subsections (6a, 6b, 7a, 7b) separated along the axial direction, in that each reference pin (6c, 7c) has, on its side facing the reference hole (2, 3), a plug (6c, 7c) having a diameter (d) which is smaller than the diameter (D) of the reference hole (2, 3), in that the assembled reference pin (6, 7) is mounted with play in a receiving sleeve (9) which embodies spring means (11) which strive to hold the subsections (6a, 6b, 7a, 7b) of the reference pin (6, 7) together, in that the reference pin (6, 7) has in the interior an axial hole (12) which ends in a conically converging seating (13), and in that a pin (14) which has a conically converging tip (15) at its free end is mounted in an axially displaceable manner in said axial hole (12) and is linked by its other end to a piston (15') which is a component of a pneumatic drive cylinder (16).

2. Device according to Patent Claim 1, characterised in that spring means (11) are provided in radially disposed seatings (11') which are disposed in the interior of the receiving sleeve (9).

3. Device according to Patent Claim 1, characterised in that the axially displaceable pin (14) ends in a piston (15') which is acted on by a spring (17) in the fashion of a single-acting cylinder (16).

4. Device according to Patent Claim (sic) 1-3, characterised in that parallel and adjacent to the reference pin (6 or 7), a bearing support (8) is provided which has a hole (19) which receives a tubular, displaceably mounted component (20) which carries at its top a sucker (21) which faces the bottom of the board (1), in that the bottom of the displaceable tubular component (20) rests on a spring (17) which is disposed in the hole (19), and in that the hole (19) is operationally linked via a line (24) with a source of vacuum.

5. Device according to Patent Claim (sic) 1-4, characterised in that at least one bearing support (8) is mounted on two parallel, horizontally disposed guides (25, 26) which are for their part disposed so as to be displaceable in the horizontal direction in a bearing part (29) which is linked in a fixed manner to the machine.

6. Device according to Patent Claim 5, characterised in that the guides (25, 26) project from the bearing part (29) and their free ends are linked to each other by means of a transverse yoke (30) and, in that spring means (31) (sic) are disposed between the bearing support (8) and the bearing part (29), and also between the bearing part (29) and the yoke (30).

7. Device according to Patent Claim 6, characterised in that the springs (31, 32) have identical spring characteristics and identical spring pretension.

8. Device according to Patent Claim 1, characterised in that the diameter (d) of the reference pin is substantially smaller than the diameter (D) of the reference hole.

9. Device according to Patent Claim 1, characterised in that the ends (6c, 7c), facing the substrate board (1) of the reference pins (6, 7) have parallel milled sections which form a step-like recess (G).

**Revendications**

1. Dispositif pour positionner et fixer une plaque de base pour circuits imprimés à l'aide de goupilles de référence et de perçages de référence où, à chaque perçage de référence (2, 3) de la plaque (1) est affectée une goupille de référence (6, 7), caractérisé en ce que la goupille de référence se compose de plusieurs pièces séparées le long de la direction axiale (6a, 6b, 7a, 7b), en ce que chaque goupille de référence (6c, 7c) présente, de son côté tourné vers le perçage de référence (2, 3), un tourillon (6c, 7c) ayant un diamètre (d) qui est plus petit que le diamètre (D) du perçage de référence (2, 3), en ce que le goupille de référence assemblée (6, 7) est logée avec un certain jeu dans une douille de réception (9) qui présente des moyens formant ressorts (11) qui sont sollicités pour maintenir ensemble les pièces (6a, 6b, 7e, 7b) de la goupille de référence (6, 7), en ce que la goupille de référence (6, 7) présente intérieurement un perçage axial (12) qui se termine en un siège conique (13) et en ce que, dans ce perçage axial (12), est logée une goupille mobile axialement (14) qui présente à son extrémité libre une pointe conique (15) et est reliée à son autre extrémité à un piston (15') qui fait partie d'un cylindre pneumatique d'entraînement (16).

2. Dispositif selon la revendication 1, caractérisé en ce que les moyens formant ressorts (11 ) sont prévus dans des sièges (11') agencés radialement qui sont agencés à l'intérieur des douilles de réception (9).

3. Dispositif selon la revendication 1, caractérisé en ce que la goupille axialement mobile (14) se termine par un piston (15') qui est sollicité par un ressort (17) à la façon d'un cylindre à simple action (16).

4. Dispositif selon la revendication 1-3, caractérisé en ce qu'un support de palier (8) est prévu parallèle et à côté de la goupille de référence (6 ou respectivement 7), lequel présente un perçage (19) qui reçoit un élément (20) de forme tubulaire et logé mobile, qui porte à son côté supérieur un extracteur (21) qui est dirigé vers le dessous de la plaque (1), en ce que le dessous de l'élément mobile tubulaire (20) repose sur un ressort (17) qui est agencé dans le perçage (19) et en ce que le perçage (19) est en liaison active, par une conduite (24), avec une source de dépression.

5. Dispositif selon la revendication 1-4, caractérisé en ce qu'au moins un support de palier (8) est logé par deux guidages parallèles horizontaux (25, 26) qui, pour leur part, sont agencés mobiles en direction horizontale dans une partie d'appui (29) qui est solidement reliée à la machine.

6. Dispositif selon la revendication 5, caractérisé en ce que les guidages (25, 26) dépassent de la partie d'appui (29) et en ce que leurs extrémités libres sont reliées l'une à l'autre par une traverse (30) et en ce qu'entre le support de palier (8) et la pièce d'appui (29) ainsi qu'entre la pièce d'appui (29) et la traverse (30) sont agencés des moyens formant ressorts (31).

7. Dispositif selon la revendication 6, caractérisé en ce que les ressorts (31, 32) présentent des caractéristiques de ressort et des tensions préalables de ressort identiques.

8. Dispositif selon la revendication 1, caractérisé en ce que le diamètre (d) de la goupille de référence est considérablement plus petit que le diamètre (D) du perçage de référence.

9. Dispositif selon la revendication 1, caractérisé en ce que les extrémités (6c, 7c) dirigées vers la plaque de base (1) des goupilles de référence (6, 7) présentent des fraisures parallèles qui forment un recul échelonné (G).

Fig. 1

EP 0 191 905 B1

Fig. 2

Fig. 3

EP 0 191 905 B1

Fig. 4

Fig. 5

Fig. 6

Fig. 7